# EUROPEAN PATENT APPLICATION

(11) **EP 4 550 390 A1**
(43) Date of publication of application: **07.05.2025**
(21) Application number: 24209541.2
(22) Date of filing: 29.10.2024
(51) Int. Cl.: H01L 21/311

(54) **SUBSTRATE PROCESSING METHOD, METHOD OF MANUFACTURING SEMICONDUCTOR DEVICE, SUBSTRATE PROCESSING APPARATUS AND PROGRAM**

(30) Priority: 02.11.2023 JP 2023188835
(71) Applicant: Kokusai Electric Corp., Tokyo 1010045 (JP)
(72) Inventor: USUKI, Kenshiro, Toyama-shi, 939-2393 (JP); YAMAZAKI, Hirohisa, Toyama-shi, 939-2393 (JP); MIZUNO, Norikazu, Toyama-shi, 939-2393 (JP)
(74) Representative: Verscht, Thomas Kurt Albert

(57) **Abstract**

According to the present disclosure, it is possible to reduce an amount of impurities contained in a film after the film is etched. There is provided a technique that includes: (a) removing at least a part of a film formed on a substrate by performing a cycle two or more times, wherein the cycle includes: (a1) supplying a first fluorine-containing gas to the substrate; and (a2) supplying a reactive gas containing a predetermined element to the substrate; and (b) supplying a second fluorine-containing gas to the substrate after (a), wherein a first substance containing the predetermined element is generated in (a), and wherein the second fluorine-containing gas is supplied in (b) under conditions in which the first substance is converted into a substance whose vapor pressure is lower than that of the first substance.

## Description

### [Technical Field]

The present disclosure relates to a substrate processing method, a method of manufacturing a semiconductor device, a substrate processing apparatus and a program.

### [Related Art]

As a part of a substrate processing (that is, a manufacturing process of a semiconductor device), a film may be etched by performing a cycle of supplying different types of gases a predetermined number of times (for example, see Patent Document 1).

### [Related Art Document]

### [Patent Document]

Patent Document 1: Japanese Patent Laid-Open No. 2021-158142

### [Disclosure]

### [Technical Problem]

According to the present disclosure, there is provided a technique capable of reducing an amount of impurities contained in a film after the film is etched.

### [Technical Solution]

According to an embodiment of the present disclosure, there is provided a technique that includes: (a) removing at least a part of a film formed on a substrate by performing a cycle two or more times, wherein the cycle includes: (a1) supplying a first fluorine-containing gas to the substrate; and (a2) supplying a reactive gas containing a predetermined element to the substrate; and (b) supplying a second fluorine-containing gas to the substrate after (a), wherein a first substance containing the predetermined element is generated in (a), and wherein the second fluorine-containing gas is supplied in (b) under conditions in which the first substance is converted into a substance whose vapor pressure is lower than that of the first substance.

### [Advantageous Effects]

According to some embodiments of the present disclosure, it is possible to reduce the amount of the impurities contained in the film after the film is etched.

### [Brief Description of Drawings]

FIG. 1 is a diagram schematically illustrating a vertical cross-section of a vertical type process furnace of a substrate processing apparatus preferably used in one or more embodiments of the present disclosure.
FIG. 2 is a diagram schematically illustrating a horizontal cross-section, taken along a line A - A shown in FIG. 1, of the vertical type process furnace of the substrate processing apparatus preferably used in the embodiments of the present disclosure.
FIG. 3 is a block diagram schematically illustrating a configuration of a controller and related components of the substrate processing apparatus preferably used in the embodiments of the present disclosure.
FIG. 4 is a flow chart schematically illustrating a substrate processing according to the embodiments of the present disclosure.
FIG. 5A is a diagram schematically illustrating an image of a film in an experimental example, and FIG. 5B is a diagram schematically illustrating SIMS (Secondary Ion Mass Spectrometry) analysis results in the experimental example.

### [Detailed Description]

### <Embodiments of Present Disclosure>

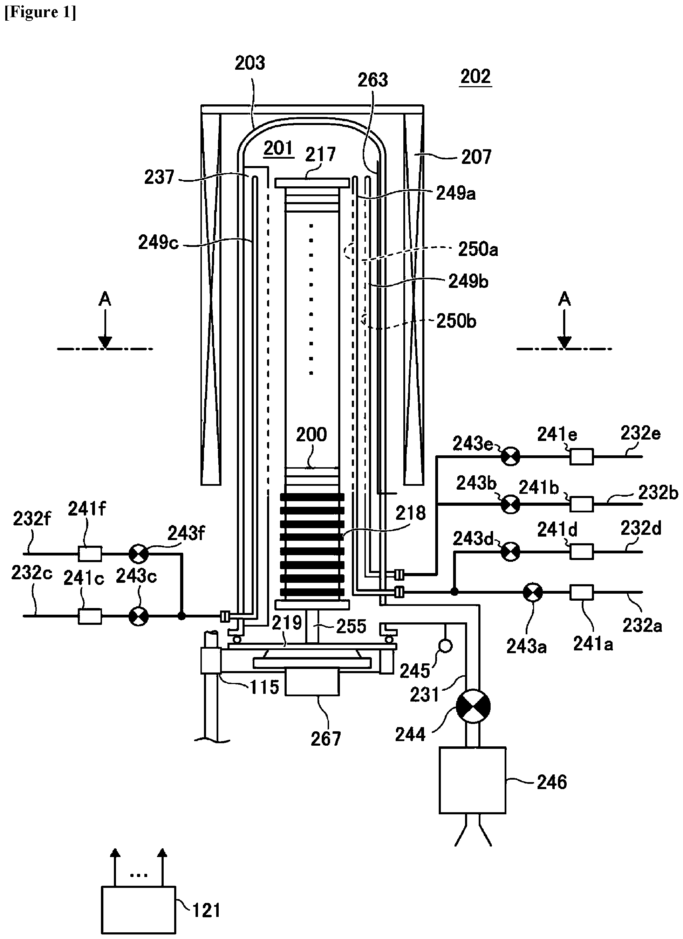

Hereinafter, one or more embodiments (also simply referred to as "embodiments") of the technique of the present disclosure will be described in detail mainly with reference to FIGS. 1 to 4. The drawings used in the following description are all schematic. For example, a relationship between dimensions of each component and a ratio of each component shown in the drawing may not always match the actual ones. Further, even between the drawings, the relationship between the dimensions of each component and the ratio of each component may not always match.

### (1) Configuration of Substrate Processing Apparatus

As shown in FIG. 1, a process furnace 202 serving as a substrate processing apparatus according to the present embodiments includes a heater 207 serving as a heating structure (which is a temperature regulator or a temperature adjusting structure). The heater 207 also functions as an activator (also referred to as an "exciter") capable of activating (or exciting) a gas by a heat. A reaction tube 203 is provided in an inner side of the heater 207. A process chamber 201 is provided in a hollow cylindrical portion of the reaction tube 203. The process chamber 201 is configured to be capable of accommodating a plurality of wafers including a wafer 200 serving as a substrate. Hereinafter, the plurality of wafers including the wafer 200 may also be simply referred to as "wafers 200". The wafer 200 is processed in the process chamber 201. Nozzles 249a, 249b and 249c are provided in the process chamber 201 so as to penetrate a lower portion of a side wall of the reaction tube 203. Gas supply pipes 232a, 232b and 232c are connected to the nozzles 249a, 249b and 249c, respectively.

Mass flow controllers (also simply referred to as "MFCs") 241a, 241b and 241c serving as flow rate controllers (flow rate control structures) and valves 243a, 243b and 243c serving as opening/closing valves are sequentially installed at the gas supply pipes 232a, 232b and 232c, respectively, in this order from upstream sides to downstream sides of the gas supply pipes 232a, 232b and 232c in a gas flow direction. A gas supply pipe 232d is connected to the gas supply pipe 232a at a downstream side of the valve 243a of the gas supply pipe 232a. A gas supply pipe 232e is connected to the gas supply pipe 232b at a downstream side of the valve 243b of the gas supply pipe 232b. A gas supply pipe 232f is connected to the gas supply pipe 232c at a downstream side of the valve 243c of the gas supply pipe 232c. MFCs 241d, 241e and 241f and valves 243d, 243e and 243f are sequentially installed at the gas supply pipes 232d, 232e and 232f, respectively, in this order from upstream sides to downstream sides of the gas supply pipes 232d, 232e and 232f in the gas flow direction.

Each of the nozzles 249a and 249b is installed in an annular space provided between an inner wall of the reaction tube 203 and the wafers 200 when viewed from above, and extends upward from a lower portion toward an upper portion of the reaction tube 203 along the inner wall of the reaction tube 203 (that is, extends upward along an arrangement direction of the wafers 200). A plurality of gas supply holes 250a and a plurality of gas supply holes 250b are provided at side surfaces of the nozzles 249a and 249b, respectively. Gases are supplied via the gas supply holes 250a and the gas supply holes 250b, respectively. The gas supply holes 250a and the gas supply holes 250b are open toward a central portion of the reaction tube 203, and are configured such that the gases are supplied toward the wafers 200 via the gas supply holes 250a and the gas supply holes 250b. The gas supply holes 250a and the gas supply holes 250b are provided from the lower portion toward the upper portion of the reaction tube 203.

The nozzle 249c is provided in a buffer chamber 237. The buffer chamber 237 is installed in a space between the inner wall of the reaction tube 203 and the wafers 200. A plurality of gas supply holes 250d through which the gas is supplied are provided on a portion of a wall constituting the buffer chamber 237. The gas supply holes 250d are open toward the central portion of the reaction tube 203. The gas supplied into the buffer chamber 237 through the nozzle 249c is then supplied to the wafer 200 via the gas supply holes 250d. The gas supply holes 250d are arranged from the lower portion toward the upper portion of the wall constituting the buffer chamber 237.

The nozzle 249c is installed on one side of the buffer chamber 237 opposite to where the gas supply holes 250d are provided, and extends upward from the lower portion toward the upper portion of the reaction tube 203 along the inner wall of the reaction tube 203 (that is, extends upward along the arrangement direction of the wafers 200). A plurality of gas supply holes 250c through which the gas is supplied are provided at a side surface of the nozzle 249c. The gas supply holes 250c are open toward a central portion of the buffer chamber 237. Similar to the gas supply holes 250d, the gas supply holes 250c are provided from the lower portion to the upper portion of the reaction tube 203.

With such a configuration mentioned above, according to the present embodiments, the gases are transferred (supplied), via the nozzles 249a through 249c and the buffer chamber 237, into a space defined by an inner portion of the side wall of the reaction tube 203 and end portions (peripheries) of the wafers 200 arranged in the reaction tube 203. The gases are then supplied toward the wafers 200 in the reaction tube 203 via the gas supply holes 250a, the gas supply holes 250b and the gas supply holes 250d (which are open toward the central portion of the reaction tube 203) and the gas supply holes 250c (which are open toward the central portion of the buffer chamber 237).

A fluorine (F)-containing gas (that is, a first fluorine-containing gas or a second fluorine-containing gas) is supplied into the process chamber 201 via the gas supply pipe 232a provided with the MFC 241a and the valve 243a and the nozzle 249a.

A reactive gas containing a predetermined element is supplied into the process chamber 201 via the gas supply pipe 232b provided with the MFC 241b and the valve 243b and the nozzle 249b.

A modifying agent is supplied into the process chamber 201 via the gas supply pipe 232c provided with the MFC 241c and the valve 243c, the nozzle 249c and the buffer chamber 237.

In the present specification, the term "agent" may contain at least one selected from the group of a gaseous substance and a liquid substance. Further, the liquid substance may contain a mist substance. That is, the modifying agent may contain a gaseous substance, may contain a liquid substance such as a mist substance, or may contain both of the gaseous substance and the liquid substance.

An inert gas is supplied into the process chamber 201 via the gas supply pipes 232d to 232f provided with the MFCs 241d to 241f and the valves 243d to 243f, respectively, the gas supply pipes 232a to 232c, the nozzles 249a to 249c and the buffer chamber 237. For example, the inert gas may act as a purge gas, a carrier gas, a dilution gas and the like.

A first fluorine-containing gas supplier (which is a first fluorine-containing gas supply structure or a first fluorine-containing gas supply system) configured to supply the first fluorine-containing gas or a second fluorine-containing gas supplier (which is a second fluorine-containing gas supply structure or a second fluorine-containing gas supply system) configured to supply the second fluorine-containing gas is constituted mainly by the gas supply pipe 232a, the MFC 241a and the valve 243a. A reactive gas supplier (which is a reactive gas supply structure or a reactive gas supply system) configured to supply the reactive gas is constituted mainly by the gas supply pipe 232b, the MFC 241b and the valve 243b. A modifying agent supplier (which is a modifying agent supply structure or a modifying agent supply system) configured to supply the modifying agent is constituted mainly by the gas supply pipe 232c, the MFC 241c and the valve 243c. Further, an inert gas supplier (which is an inert gas supply structure or an inert gas supply system) configured to supply the inert gas is constituted mainly by the gas supply pipes 232d to 232f, the MFCs 241d to 241f and the valves 243d to 243f.

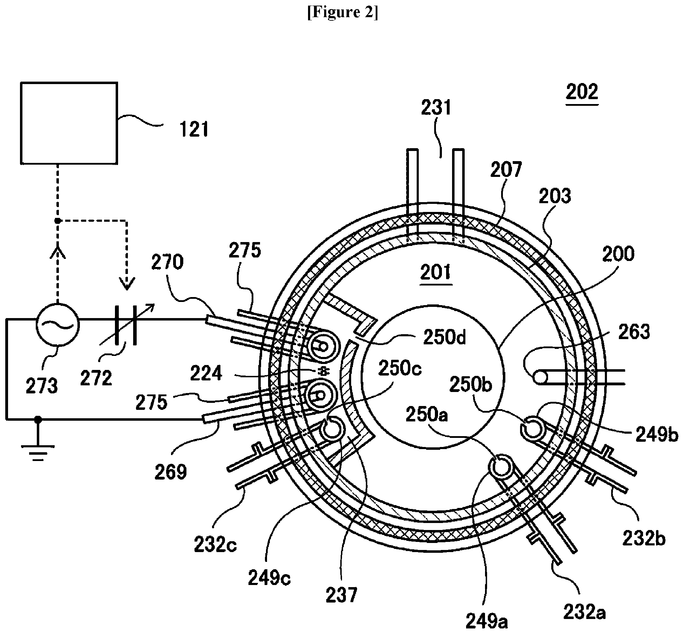

As shown in FIG. 2, in the buffer chamber 237, two rod-shaped electrodes 269 and 270 made of a conductor are provided from the lower portion toward the upper portion of the reaction tube 203 along the arrangement direction (stacking direction) of the wafers 200. Each of the rod-shaped electrodes 269 and 270 is provided parallel to the nozzle 249c. Each of the rod-shaped electrodes 269 and 270 is covered and protected by an electrode protecting pipe 275 from an upper portion to a lower portion thereof. One of the two rod-shaped electrodes 269 and 270 is connected to a high frequency power supply 273 through a matcher (which is a matching structure) 272, and the other one of the two rod-shaped electrodes 269 and 270 is grounded to an electrical ground serving as a reference potential. By applying a high frequency power (RF power) to the rod-shaped electrodes 269 and 270 from the high frequency power supply 273 via the matcher 272, the plasma is generated in a plasma generation region 224 between the rod-shaped electrodes 269 and 270. A plasma source serving as a plasma generator (plasma generating structure) is constituted mainly by the rod-shaped electrodes 269 and 270 provided in the buffer chamber 237 and the electrode protecting pipe 275. The plasma source may further include the matcher 272 and the high frequency power supply 273. As described later, the plasma source acts as a plasma activator (plasma exciter) capable of activating (or exciting) the gas into a plasma state.

An exhaust pipe 231 through which the gases in the process chamber 201 are exhausted is provided at the lower portion of the side wall of the reaction tube 203. A vacuum pump 246 serving as a vacuum exhaust apparatus is connected to the exhaust pipe 231 through a pressure sensor 245 and an APC (Automatic Pressure Controller) valve 244. The pressure sensor 245 serves as a pressure detector (pressure detection structure) configured to detect an inner pressure of the process chamber 201, and the APC valve 244 serves as a pressure regulator (pressure adjusting structure). With the vacuum pump 246 in operation, the APC valve 244 may be opened or closed to perform a vacuum exhaust operation for the process chamber 201 or stop the vacuum exhaust operation. Further, with the vacuum pump 246 in operation, the inner pressure of the process chamber 201 may be adjusted by adjusting an opening degree of the APC valve 244 based on pressure information detected by the pressure sensor 245. An exhauster (which is an exhaust structure or an exhaust system) is constituted mainly by the exhaust pipe 231, the APC valve 244 and the pressure sensor 245. The exhauster may further include the vacuum pump 246.

A seal cap 219 capable of airtightly sealing (or closing) a lower end opening of the reaction tube 203 is provided under the reaction tube 203. A rotator (which is a rotating structure) 267 configured to rotate a boat 217 described later is provided under the seal cap 219. A rotating shaft 255 of the rotator 267 penetrates through the seal cap 219 such that the rotating shaft 255 is connected to the boat 217. As the rotator 267 rotates the boat 217, the wafers 200 accommodated in the boat 217 are rotated. The seal cap 219 is elevated or lowered in the vertical direction by a boat elevator 115 serving as an elevating structure provided outside the reaction tube 203. The boat elevator 115 serves as a transfer device (which is a transfer structure or a transfer system) capable of transferring (loading) the wafers 200 into the process chamber 201 and capable of transferring (unloading) the wafers 200 out of the process chamber 201 by elevating and lowering the seal cap 219.

The boat 217 serving as a substrate support (or a substrate retainer) is configured such that the wafers 200 (for example, from 25 wafers to 200 wafers) are accommodated (or supported) in the vertical direction in the boat 217 while the wafers 200 are horizontally oriented with their centers aligned with one another in a multistage manner. Further, a plurality of heat insulation plates 218 are supported at a lower portion of the boat 217 while the heat insulation plates 218 are horizontally oriented with their centers aligned with one another in a multistage manner. Further, in the present specification, a notation of a numerical range such as "from 25 wafers to 200 wafers" means that a lower limit and an upper limit are included in the numerical range. Therefore, for example, the numerical range "from 25 wafers to 200 wafers" means a range equal to or higher than 25 wafers and equal to or less than 200 wafers. The same also applies to other numerical ranges described in the present specification.

A temperature sensor 263 serving as a temperature detector is installed in the reaction tube 203. A state of electric conduction to the heater 207 is adjusted based on temperature information detected by the temperature sensor 263 such that a desired temperature distribution of an inner temperature of the process chamber 201 can be obtained.

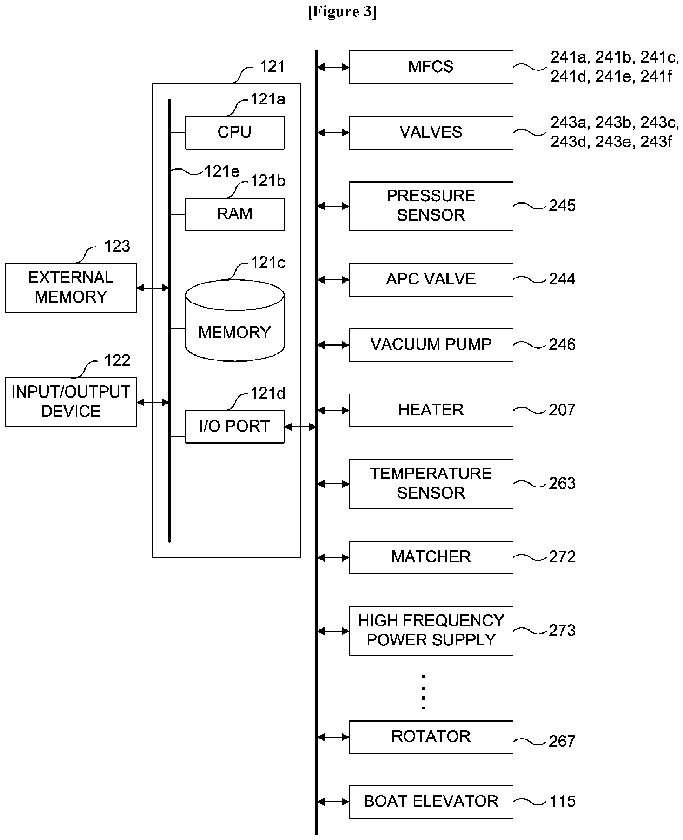

As shown in FIG. 3, a controller 121 serving as a control structure (control apparatus) is constituted by a computer including a CPU (Central Processing Unit) 121a, a RAM (Random Access Memory) 121b, a memory 121c and an I/O port (input/output port) 121d. The RAM 121b, the memory 121c and the I/O port 121d may exchange data with the CPU 121a through an internal bus 121e. For example, an input/output device 122 constituted by a component such as a touch panel is connected to the controller 121. Further, the controller 121 is configured to be capable of being connected to an external memory 123. For example, as the controller 121, the substrate processing apparatus may include a single control structure, or include a plurality of control structures. That is, a control operation of performing a substrate processing described later may be performed using the single control structure, or may be performed using the plurality of control structures. Thus, in the present specification, the term "controller 121" may refer to the single control structure, or may refer to the plurality of control structures.

For example, the memory 121c is configured by a component such as a flash memory and a hard disk drive (HDD). For example, a control program configured to control an operation of the substrate processing apparatus and a process recipe containing information on procedures and conditions of the substrate processing such as an etching process described later may be readably stored in the memory 121c. The process recipe is obtained by combining steps (procedures or processes) of the substrate processing such as the etching process described later such that the controller 121 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 121b functions as a memory area (work area) where a program or data read by the CPU 121a is temporarily stored.

The I/O port 121d is connected to the components described above such as the MFCs 241a to 241f, the valves 243a to 243f, the pressure sensor 245, the APC valve 244, the vacuum pump 246, the temperature sensor 263, the heater 207, the matcher 272, the high frequency power supply 273, the rotator 267 and the boat elevator 115.

The CPU 121a is configured to read the control program from the memory 121c and execute the read control program. In addition, the CPU 121a is configured to read the recipe from the memory 121c, for example, in accordance with an operation command inputted from the input/output device 122. In accordance with contents of the read recipe, the CPU 121a may be configured to be capable of controlling various operations such as flow rate adjusting operations for various gases by the MFCs 241a to 241f, opening and closing operations of the valves 243a to 243f, an opening and closing operation of the APC valve 244, a pressure regulating operation (pressure adjusting operation) by the APC valve 244 based on the pressure sensor 245, a start and stop operation of the vacuum pump 246, a temperature regulating operation (temperature adjusting operation) by the heater 207 based on the temperature sensor 263, a power supply operation of the high frequency power supply 273, an impedance matching operation by the matcher 272, an operation of adjusting a rotation and a rotation speed of the boat 217 by the rotator 267 and an elevating and lowering operation of the boat 217 by the boat elevator 115.

The controller 121 may be embodied by installing the above-described program stored in the external memory 123 into the computer. For example, the external memory 123 may include a magnetic disk such as the HDD, an optical disk such as a CD, a magneto-optical disk such as an MO and a semiconductor memory such as a USB memory. The memory 121c or the external memory 123 may be embodied by a non-transitory computer readable recording medium. Hereafter, the memory 121c and the external memory 123 may be collectively or individually referred to as a "recording medium". Thus, in the present specification, the term "recording medium" may refer to the memory 121c alone, may refer to the external memory 123 alone, or may refer to both of the memory 121c and the external memory 123. Instead of the external memory 123, a communication interface such as the Internet and a dedicated line may be used for providing the program to the computer.

### (2) Substrate Processing

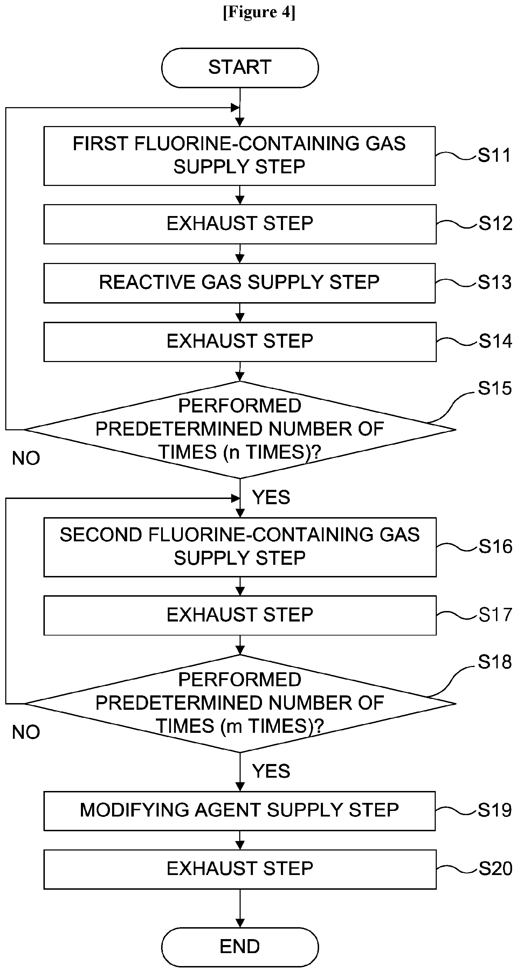

Hereinafter, an example of the etching process of etching at least a part of a film formed on a surface of the wafer 200 by using the process furnace 202 described above, which is a part of a manufacturing process of a semiconductor device, will be described with reference to FIG. 4. In the following description, operations of components constituting the process furnace 202 are controlled by the controller 121.

In the present specification, a process sequence of the substrate processing shown in FIG. 4 may be illustrated as follows for convenience. The same also applies to other process sequences described later.

(First fluorine-containing gas → Reactive gas) × n → Second fluorine-containing gas × m → Modifying agent

In the present specification, the term "wafer" may refer to "a wafer itself', or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself', or may refer to "a surface of a predetermined layer (or a predetermined film) formed on a wafer". Thus, in the present specification, "forming a predetermined layer (or a film) on a wafer" may refer to "forming a predetermined layer (or a film) directly on a surface of a wafer itself', or may refer to "forming a predetermined layer (or a film) on a surface of another layer (or another film) formed on a wafer". In the present specification, the terms "substrate" and "wafer" may be used as substantially the same meaning.

### <Wafer Charging Step and Boat Loading Step>

The wafers 200 on which the film to be etched is formed are charged (transferred) into the boat 217 (wafer charging step). Thereafter, the boat 217 supporting the wafers 200 is elevated by the boat elevator 115 and loaded (transferred) into the process chamber 201 (boat loading step).

### <Pressure Adjusting Step and Temperature Adjusting Step>

The vacuum pump 246 vacuum-exhausts (decompresses and exhausts) an inner atmosphere of the process chamber 201 (that is, a space in which the wafers 200 are present (accommodated)) such that the inner pressure of the process chamber 201 reaches and is maintained at a desired process pressure (vacuum degree). Further, the heater 207 heats the wafer 200 in the process chamber 201 such that a temperature of the wafer 200 in the process chamber 201 reaches and is maintained at a desired process temperature. In addition, a rotation of the wafer 200 is started by the rotator 267. The vacuum pump 246 continuously vacuum-exhausts the inner atmosphere of the process chamber 201, the heater 207 continuously heats the wafer 200 in the process chamber 201 and the rotator 267 continuously rotates the wafer 200 until at least a processing of the wafer 200 is completed.

In the present specification, the term "process temperature" may refer to the temperature of the wafer 200 or may refer to the inner temperature of the process chamber 201, and the term "process pressure" may refer to the inner pressure of the process chamber 201. In addition, the term "process time" may refer to a time duration of continuously performing a process related thereto. The same also applies to the following description.

Thereafter, the following steps S11 to S20 are performed on the wafer 200 on which the film to be etched is formed.

In the present embodiment, as the film to be etched, for example, a metal oxide film or a metal nitride film may be used. As a metal element contained in the metal oxide film or the metal nitride film, for example, a metal element such as aluminum (Al), zirconium (Zr), hafnium (Hf), titanium (Ti), yttrium (Y), lanthanum (La), tantalum (Ta), niobium (Nb), ruthenium (Ru), vanadium (V), zinc (Zn), manganese (Mn), cobalt (Co), indium (In) and gallium (Ga) may be used. As the metal oxide film or the metal nitride film, for example, a film containing two or more elements among the metal elements exemplified above may be used. In particular, the technique of the present disclosure may be preferably applied when etching a high dielectric constant film (high-k film) such as an aluminum oxide (Al₂O₃) film, a zirconium oxide (ZrO₂) film, a hafnium oxide (HfO₂) film, a titanium oxide (TiO₂) film, a lanthanum oxide (La₂O₃) film and a tantalum oxide (Ta₂O₅) film.

### <First Fluorine-containing Gas Supply Step: S11>

In the present step, the first fluorine-containing gas is supplied onto the wafer 200 in the process chamber 201. Specifically, the valve 243a is opened to supply the first fluorine-containing gas into the gas supply pipe 232a. After a flow rate of the first fluorine-containing gas is adjusted by the MFC 241a, the first fluorine-containing gas whose flow rate is adjusted is supplied into the process chamber 201 through the nozzle 249a, and is exhausted through the exhaust pipe 231. In the present step, the valves 243d through 243f are opened to supply the inert gas into the gas supply pipes 232d to 232f.

In the present step, the first fluorine-containing gas is supplied to the wafer 200 on which the film to be etched is formed. As a result, at least a part of an atomic layer on an uppermost surface (top surface) of the wafer 200 is converted into a substance containing fluorine. In other words, the atomic layer on the uppermost surface of the film on the wafer 200 is modified into a layer containing fluorine and the like.

For example, process conditions of supplying the first fluorine-containing gas in the present step are as follows:
A process temperature: from 200 °C to 900 °C;
A process pressure: from 10 Pa to 7,000 Pa;
A supply time (time duration) of supplying each gas: from 20 seconds to 1,000 seconds; and
A process partial pressure of the first fluorine-containing gas: from 10 Pa to 4,000 Pa.

Further, the process temperature is set to be substantially the same in each of the steps described below.

In the present specification, the term "supply time" of a certain gas may refer to a time duration of supplying the certain gas onto the wafer 200 or into the process chamber 201. Further, the term "process partial pressure" of the certain gas may refer to a partial pressure of the certain gas in the process chamber 201. The same also applies to the following description.

As the first fluorine-containing gas, for example, at least one among fluorine (F₂), nitrogen trifluoride (NF₃), hydrogen fluoride (HF), carbon tetrafluoride (CF₄), tungsten hexafluoride (WF₆), chlorine trifluoride (ClF₃), sulfur tetrafluoride (SF₄), xenon difluoride (XeF₂) and the like may be used. That is, as the first fluorine-containing gas, one or more of the substances exemplified above may be used. Further, it is preferable that a gas free of a metal element (that is, a gas that does not contain a metal element) is used as the first fluorine-containing gas. In such a case, it is difficult for impurities derived from the first fluorine-containing gas to be contained in the film. Thereby, it is possible to improve electrical characteristics of the film. In addition, it is preferable that a gas containing fluorine and an element that does not constitute a film by itself is used as the first fluorine-containing gas. As such a gas, for example, a gas such as the F₂, the NF₃, the HF and the XeF₂ may be used. In such a case, it is possible to further reduce an amount of the impurities contained in the film. Thereby, it is possible to suppress a deterioration of the electrical characteristics of the film.

As the inert gas, for example, nitrogen (N₂) gas or a rare gas such as argon (Ar) gas, helium (He) gas, neon (Ne) gas and xenon (Xe) gas may be used. That is, as the inert gas, one or more of the substances exemplified above may be used.

### <Exhaust Step: S12>

The valve 243a is closed to stop a supply of the first fluorine-containing gas into the process chamber 201. In the present step, with the APC valve 244 of the exhaust pipe 231 open, the vacuum pump 246 vacuum-exhausts the inner atmosphere of the process chamber 201. Thereby, it is possible to remove a residual gas (for example, the first fluorine-containing gas (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open. In such a case, the inert gas acts as the purge gas, which improves an efficiency of removing the residual gas from above the wafer 200.

In the present step, it is preferable that the process chamber 201 (that is, the space in which the wafers 200 are present) is vacuum-exhausted and purged. Thereby, it is possible to reduce the amount of the impurities contained in the film after the etching process. In other words, it is possible to suppress the deterioration of the electrical characteristics of the film due to the impurities in the film.

For example, process conditions of vacuum-exhausting the process chamber 201 in the present step are as follows:
A process pressure: from 10 Pa to 200 Pa; and
A process time: from 10 seconds to 180 seconds.

For example, process conditions of purging the process chamber 201 in the present step are as follows:
A process pressure: from 10 Pa to 7,000 Pa; and
A process time: from 30 seconds to 180 seconds.

### <Reactive Gas Supply Step: S13>

Subsequently, the reactive gas is supplied onto the wafer 200 in the process chamber 201. Specifically, the valve 243b is opened to supply the reactive gas into the gas supply pipe 232b. After a flow rate of the reactive gas is adjusted by the MFC 241b, the reactive gas whose flow rate is adjusted is supplied into the process chamber 201 through the nozzle 249b, and is exhausted through the exhaust pipe 231. In the present step, the valves 243d through 243f are opened to supply the inert gas into the gas supply pipes 232d to 232f.

In the present step, the reactive gas is supplied to the wafer 200 where a layer of the substance containing fluorine (such as the layer containing fluorine and the like mentioned above) is formed on the surface thereof. Thereby, it is possible to convert (or modify) at least a part of the substance containing fluorine on the wafer 200 into a volatile product containing an element derived from the film to be etched. In other words, it is possible to remove at least a part of the film on the wafer 200.

For example, process conditions of supplying the reactive gas in the present step are as follows:
A process pressure: from 10 Pa to 7,000 Pa;
A supply time (time duration) of supplying each gas: from 60 seconds to 600 seconds; and
A process partial pressure of the reactive gas: from 10 Pa to 4,000 Pa.

As the reactive gas, for example, a gas containing a predetermined element and chlorine (Cl) may be used. As the predetermined element, for example, at least one among boron (B), carbon (C), sulfur (S), phosphorus (P), titanium (Ti), silicon (Si), aluminum (Al), tin (Sn) and the like may be used. As the gas containing the predetermined element and chlorine, for example, a gas such as boron trichloride (BC1₃), carbon tetrachloride (CCl₄), thionyl chloride (SOCl₂), sulfuryl chloride (SO₂Cl₂), phosgene (COCl₂), phosphorus trichloride (PCl₃), phosphorus pentachloride (PCl₅), titanium tetrachloride (TiCl₄), silicon tetrachloride (SiCl₄) and chlorodimethylaluminum (C₂H₆AlCl) may be used.

Further, as the reactive gas, for example, a gas containing the predetermined element and an organic ligand may be used. In such a case, carbon (C) contained in the organic ligand may be considered as one of the predetermined elements. As the gas containing the predetermined element and the organic ligand, for example, a gas such as trimethylaluminum ((CH₃)₃Al), C₂H₆AlCl, tin (II) acetylacetonate (Sn(acac)₂) may be used. As the reactive gas, one or more of the substances exemplified above may be used.

When a gas containing a metalloid or metal element (for example, boron (B), titanium (Ti), silicon (Si), aluminum (Al) or tin (Sn)) as the predetermined element is used as the reactive gas, the predetermined element is likely to remain in the film. According to the technique of the present disclosure, it is possible to reduce an amount of the predetermined element contained in the film. Therefore, the technique of the present disclosure can be suitably applied. Further, among the metalloid or metal element serving as the predetermined element, an element belonging to the second or third period (for example, boron (B), carbon (C), phosphorus (P), silicon (Si) or aluminum (Al)) is easily removed by the fluorine-containing gas. Therefore, the technique of the present disclosure can be suitably applied.

In the present step, a substance (hereinafter, also referred to as a "substance X") containing the predetermined element contained in the reactive gas may be generated on the surface of the film. Hereinafter, the substance X may also be referred to as a "first substance". For example, the substance X may be a simple substance of the predetermined element, a compound of oxygen (O) and fluorine (F), an oxide, a compound of nitrogen (N) and fluorine (F) or a nitride. By appropriately selecting a type of the predetermined element or a type of the reactive gas, it is possible to cause the substance X (which is volatile) to be generated. However, even in such a case, a part of the substance X (which is volatile) may not be removed from the wafer 200, and the predetermined element may remain in the film. By approximately selecting the type of the predetermined element or the type of the reactive gas, it is possible to remove the substance X from the wafer 200 as a volatile substance. However, even in such a case, a part of the substance X may not be removed from the wafer 200, and the predetermined element may remain in the film.

### <Exhaust Step: S14>

The valve 243b is closed to stop a supply of the reactive gas into the process chamber 201. In the present step, with the APC valve 244 of the exhaust pipe 231 open, the vacuum pump 246 vacuum-exhausts the inner atmosphere of the process chamber 201. Thereby, it is possible to remove a residual gas (for example, the reactive gas (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open.

In the present step, it is preferable that the process chamber 201 (that is, the space in which the wafers 200 are present) is vacuum-exhausted and purged. Thereby, it is possible to reduce an amount of the substance X contained in the film after the etching process. In other words, it is possible to suppress the deterioration of the electrical characteristics of the film due to the predetermined element contained in the film.

For example, as process conditions of vacuum-exhausting the process chamber 201 and process conditions of purging the process chamber 201 in the present step, the process conditions of vacuum-exhausting the process chamber 201 and the process conditions of purging the process chamber 201 in the exhaust step S12 may be used, respectively.

### <Performing Predetermined Number of Times: Step S15>

By performing a cycle (hereinafter, also referred to as "etching cycle") (in which the steps S11 to S14 described above are sequentially performed in this order) a predetermined number of times (n times, n is an integer of 2 or more), it is possible to remove (hereinafter, also referred to as "etch") at least a part of the film on the wafer 200. For example, n is an integer within a range from 2 to 100.

In the step S 11 of second and later executions of the etching cycle, it is preferable to supply the first fluorine-containing gas under conditions in which the substance X is converted into a substance whose vapor pressure is lower than that of the substance X. Thereby, it is possible to reduce the amount of the predetermined element remaining in the film to be etched.

In the present embodiments, in the second and later executions of the etching cycle, it is preferable to perform the step S11 under conditions in which a part of the substance X containing the predetermined element (which becomes the impurities thereafter) is not removed from the wafer 200. Thereby, it is possible to shorten a time for performing the etching process. Further, the substance X remaining on the wafer 200 without being removed therefrom in the present step can be removed from the film in a step S16 described later. Thus, it is possible to reduce the amount of the predetermined element remaining in the film to be etched while improving the throughput.

For example, in the step S11 of the second and later executions of the etching cycle, an exposure amount of the first fluorine-containing gas may be set to be smaller than an exposure amount of the first fluorine-containing gas in a case where the substance X on the wafer 200 is completely removed. In such a case, it is possible to perform the step S11 under conditions in which a part of the substance X is not removed from the wafer 200.

In the present specification, for example, the "exposure amount of the first fluorine-containing gas in the step S11" is calculated as "an integral of the process partial pressure of the first fluorine-containing gas in the space (that is, the process chamber 201) in which the wafer 200 are present in the step S11 by the time from a start to an end of the step S11". Further, for example, the "process partial pressure of the first fluorine-containing gas" is calculated as "the product of a mole fraction of the first fluorine-containing gas and a pressure (total pressure) in the space in which the wafer 200 are present at a certain time". In addition, when the process partial pressure of the first fluorine-containing gas in the space in which the wafer 200 are present in the step S11 can be considered to be constant, the "exposure amount of the first fluorine-containing gas in the step S11" is calculated as "the product of the process partial pressure of the first fluorine-containing gas and the time from the start to the end of the step S11".

That is, in the step S11 of the second and later executions of the etching cycle, the supply time of the first fluorine-containing gas may be set to be shorter than the supply time of the first fluorine-containing gas in a case where the substance X on the wafer 200 is completely removed. Further, the process partial pressure of the first fluorine-containing gas may be set to be lower than the process partial pressure of the first fluorine-containing gas in a case where the substance X on the wafer 200 is completely removed. By using one or both of the settings mentioned above, the exposure amount of the first fluorine-containing gas in the step S11 of the second and later executions of the etching cycle can be set to be smaller than the exposure amount of the first fluorine-containing gas in a case where the substance X on the wafer 200 is completely removed.

Further, in the step S11 of the second and later executions of the etching cycle, the process pressure may be set to be higher than the process pressure in a case where the substance X on the wafer 200 is completely removed. In addition, the mole fraction of the first fluorine-containing gas in the process chamber 201 may be set to be higher than the mole fraction of the first fluorine-containing gas in the process chamber 201 in a case where the substance X on the wafer 200 is completely removed. By using one or both of the settings mentioned above, the process partial pressure of the first fluorine-containing gas in the step S11 of the second and later executions of the etching cycle can be set to be higher than the process partial pressure of the first fluorine-containing gas in a case where the substance X on the wafer 200 is completely removed.

Further, in the step S11 of the second and later executions of the etching cycle, a supply flow rate of the first fluorine-containing gas may be set to be greater than a supply flow rate of the first fluorine-containing gas in a case where the substance X on the wafer 200 is completely removed. In addition, a supply flow rate of the inert gas in the present step may be set to be smaller than a supply flow rate of the inert gas in a case where the substance X on the wafer 200 is completely removed. By using one or both of the settings mentioned above, the mole fraction of the first fluorine-containing gas in the process chamber 201 in the step S11 of the second and later executions of the etching cycle can be set to be higher than the mole fraction of the first fluorine-containing gas in the process chamber 201 in a case where the substance X on the wafer 200 is completely removed.

In the present specification, the term "supply flow rate" of a certain gas may refer to a flow rate of the gas being supplied onto the wafer 200 or into the process chamber 201. The same also applies to the following description.

According to the present embodiments, after the etching cycle is performed a predetermined number of times, the second fluorine-containing gas is supplied in the step S16.

### <Second Fluorine-containing Gas Supply Step: S16>

In the present step, the second fluorine-containing gas is supplied onto the wafer 200 in the process chamber 201. Specifically, the valve 243a is opened to supply the second fluorine-containing gas into the gas supply pipe 232a. After a flow rate of the second fluorine-containing gas is adjusted by the MFC 241a, the second fluorine-containing gas whose flow rate is adjusted is supplied into the process chamber 201 through the nozzle 249a, and is exhausted through the exhaust pipe 231. In the present step, the valves 243d through 243f are opened to supply the inert gas into the gas supply pipes 232d to 232f.

In the present step, the second fluorine-containing gas is supplied to the wafer 200 under conditions in which the substance X is converted into a substance whose vapor pressure is lower than that of the substance X. That is, in the present step, the substance X containing the predetermined element is converted into a volatile substance and discharged (or exhausted) from the process chamber 201. As a result, it is possible to further reduce the amount of the predetermined element contained in the film on the wafer 200. Thereby, it is possible to improve the electrical characteristics of the film.

For example, it is preferable that an exposure amount of the second fluorine-containing gas in present step is set to be greater than the exposure amount of the first fluorine-containing gas in the step S11 described above. As a result, it is possible to reduce the amount of the predetermined element (which becomes the impurities thereafter) contained in the film. Thereby, it is possible to improve the electrical characteristics of the film. For example, when the first fluorine-containing gas is used as the second fluorine-containing gas, the exposure amount of the second fluorine-containing gas in the present step is set to be greater than the exposure amount of the first fluorine-containing gas in the step S11 described above. As a result, it is possible to reduce the amount of the predetermined element contained in the film.

For example, a supply time of the second fluorine-containing gas in the present step may be set to be longer than the supply time of the first fluorine-containing gas in the step S11. Further, a process partial pressure of the second fluorine-containing gas in the present step may be set to be higher than the process partial pressure of the first fluorine-containing gas in the step S11. By using one or both of the settings mentioned above, the exposure amount of the second fluorine-containing gas in the present step can be set to be greater than the exposure amount of the first fluorine-containing gas in the step S11.

For example, a process pressure in the present step may be set to be higher than the process pressure in the step S11. Further, a mole fraction of the second fluorine-containing gas in the process chamber 201 in the present step may be set to be higher than the mole fraction of the first fluorine-containing gas in the process chamber 201 in the step S11. By using one or both of the settings mentioned above, the process partial pressure of the second fluorine-containing gas in the present step can be set to be greater than the process partial pressure of the first fluorine-containing gas in the step S11.

For example, a supply flow rate of the second fluorine-containing gas in the present step may be set to be greater than the supply flow rate of the first fluorine-containing gas in the step S11. Further, a supply flow rate of the inert gas in the present step may be set to be smaller than the supply flow rate of the inert gas in the step S11. By using one or both of the settings mentioned above, the mole fraction of the second fluorine-containing gas in the process chamber 201 in the present step can be set to be higher than the mole fraction of the first fluorine-containing gas in the process chamber 201 in the step S11.

For example, process conditions of supplying the second fluorine-containing gas in the present step are as follows:
The process temperature: from 200 °C to 900 °C;
The process pressure: from 10 Pa to 10,000 Pa;
The supply time (time duration) of supplying each gas: from 20 seconds to 1,200 seconds; and
The process partial pressure of the second fluorine-containing gas: from 10 Pa to 5,000 Pa.

As the second fluorine-containing gas, for example, one or more of the gases exemplified as the first fluorine-containing gas may be used. In addition, as the second fluorine-containing gas, a gas whose type is substantially the same as the first fluorine-containing gas (that is, a gas whose molecular structure is substantially the same as the first fluorine-containing gas) may be used. In such a case, it is possible to simplify a gas supplier (which is a gas supply structure or a gas supply system) and it is also possible to simplify the process sequence. In addition, as the second fluorine-containing gas, it is preferable to use a gas free of the metal element. In such a case, it is difficult for impurities derived from the second fluorine-containing gas to be contained in the film. Thereby, it is possible to improve the electrical characteristics of the film. Further, it is preferable that a gas containing fluorine and an element that does not constitute a film by itself is used as the second fluorine-containing gas. In such a case, it is possible to further reduce the amount of the impurities contained in the film. Thereby, it is possible to suppress the deterioration of the electrical characteristics of the film.

### <Exhaust Step: S17>

The valve 243a is closed to stop a supply of the second fluorine-containing gas into the process chamber 201. In the present step, with the APC valve 244 of the exhaust pipe 231 open, the vacuum pump 246 vacuum-exhausts the inner atmosphere of the process chamber 201. Thereby, it is possible to remove a residual gas (for example, the second fluorine-containing gas (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open.

In the present step, it is preferable that the process chamber 201 (that is, the space in which the wafers 200 are present) is vacuum-exhausted and purged. Thereby, it is possible to reduce the amount of the substance X contained in the film on the wafer 200 after the etching process. In other words, it is possible to suppress the deterioration of the electrical characteristics of the film due to predetermined element contained in the film.

For example, as process conditions of vacuum-exhausting the process chamber 201 and process conditions of purging the process chamber 201 in the present step, the process conditions of vacuum-exhausting the process chamber 201 and the process conditions of purging the process chamber 201 in the exhaust step S12 may be used, respectively.

### <Performing Predetermined Number of Times: Step S18>

A cycle (in which the steps S16 to S17 described above are sequentially performed in this order) is performed a predetermined number of times (m times, m is an integer of 1 or more). For example, m is an integer within a range from 1 to 20.

According to the present embodiment, after the steps S11 to S18 described above are performed, a modifying agent supply step S19 of removing a substance (hereinafter, also referred to as a "substance Y") containing a predetermined element such as fluorine (F) contained in the film on a subsequent wafer 200 may be performed. Hereinafter, the substance Y may also be referred to as a "second substance".

### <Modifying Agent Supply Step: S19>

Subsequently, the modifying agent capable of removing the substance Y contained in the film of the wafer 200 is supplied onto the wafer 200 in the process chamber 201. Specifically, the valve 243c is opened to supply the modifying agent into the gas supply pipe 232c. After a flow rate of the modifying agent is adjusted by the MFC 241c, the modifying agent whose flow rate is adjusted is supplied into the process chamber 201 through the nozzle 249c and the buffer chamber 237, and is exhausted through the exhaust pipe 231. In the present step, the valves 243d through 243f are opened to supply the inert gas into the gas supply pipes 232d to 232f.

By supplying the modifying agent, the substance Y contained in the film of the wafer 200 is removed. Thereby, it is possible to remove the substance Y contained in the film of the wafer 200 after the steps S11 to S18 described above. That is, it is possible to reduce the amount of the impurities such as fluorine contained in the film on the wafer 200. Thereby, it is possible to improve the electrical characteristics of the film.

According to the present embodiments, the modifying agent may be in a liquid phase or a gaseous phase. As the modifying agent, for example, a substance such as an oxidizing gas may be used. The present embodiments will be described by way of an example in which the oxidizing gas is used as the modifying agent.

For example, process conditions of supplying the oxidizing gas to the wafer 200 in the present step are as follows:
A process temperature: from 300 °C to 1,000 °C;
A process pressure: from 10 Pa to 1,000 Pa; and
A supply time (time duration) of supplying each gas: from 0.5 hour to 10 hours.

As the oxidizing gas, for example, a gas containing oxygen (O) and hydrogen (H) may be used. As the gas containing oxygen and hydrogen, for example, a gas such as water vapor (H₂O), hydrogen peroxide (H₂O₂), formic acid (HCOOH), hydrogen (H₂) + oxygen (O₂) and hydrogen (H₂) + ozone (O₃) may be used. Instead of or in addition to the gas containing oxygen and hydrogen, for example, an oxygen (O)-containing gas may be used as the oxidizing gas. As the oxygen-containing gas, for example, a gas such as oxygen (O₂), ozone (O₃), nitrous oxide (N₂O), nitric oxide (NO), nitrogen dioxide (NO₂), carbon monoxide (CO) and carbon dioxide (CO₂) may be used. In addition, the gas containing oxygen and hydrogen may also be used as one of the oxygen-containing gas. That is, as the oxidizing gas, one or more of the gases exemplified above may be used. When the gas containing oxygen and hydrogen is used as the oxidizing gas, it is possible to suppress an excessive oxidation of the film on the wafer 200 and a base film (underlying film) thereof.

Further, in the present specification, the description of two gases together such as "hydrogen (H₂) + oxygen (O₂)" may refer to a mixed gas (gaseous mixture) of hydrogen (H₂) and oxygen (O₂). When a mixed gas is supplied, the two gases may be mixed (pre-mixed) in a supply pipe and then supplied into the process chamber 201, or the two gases may be separately supplied into the process chamber 201 through different supply pipes and mixed (post-mixed) in the process chamber 201.

### <Exhaust Step: S20>

The valve 243c is closed to stop a supply of the modifying agent into the process chamber 201. In the present step, with the APC valve 244 of the exhaust pipe 231 open, the vacuum pump 246 vacuum-exhausts the inner atmosphere of the process chamber 201. Thereby, it is possible to remove a residual gas (for example, the modifying agent (which remains unreacted) and reaction by-products remaining on the wafer 200 and/or in the process chamber 201) from the process chamber 201. In the present step, the process chamber 201 may be purged by continuously supplying the inert gas into the process chamber 201 with the valves 243d to 243f open.

For example, as process conditions of vacuum-exhausting the process chamber 201 and process conditions of purging the process chamber 201 in the present step, the process conditions of vacuum-exhausting the process chamber 201 and the process conditions of purging the process chamber 201 in the exhaust step S12 may be used, respectively.

### <After-purge Step and Returning to Atmospheric Pressure Step>

Subsequently, the inert gas is supplied into the process chamber 201 through each of the gas supply pipes 232d to 232f, and then is exhausted through the exhaust pipe 231. Thereby, the process chamber 201 is purged with the inert gas. As a result, a substance such as the residual gas remaining in the process chamber 201 and the reaction by-product remaining in the process chamber 201 can be removed from the process chamber 201 (after-purge step). Thereafter, the inner atmosphere of the process chamber 201 is replaced with the inert gas (substitution by inert gas), and the inner pressure of the process chamber 201 is returned to the normal pressure (atmospheric pressure) (returning to atmospheric pressure step).

### <Boat Unloading Step and Wafer Discharging Step>

Thereafter, the seal cap 219 is lowered by the boat elevator 115 and the lower end of the reaction tube 203 is opened. Then, the boat 217 with the wafers 200 (which are processed and supported in the boat 217) is unloaded (transferred) out of the reaction tube 203 through the lower end of the reaction tube 203 (boat unloading step). Then, the wafers 200 (which are processed) are discharged (transferred) from the boat 217 unloaded out of the reaction tube 203 (wafer discharging step).

### <Other Embodiments of Present Disclosure>

While the technique of the present disclosure is described in detail by way of the embodiments mentioned above, the technique of the present disclosure is not limited thereto. The technique of the present disclosure may be modified in various ways without departing from the scope thereof.

### <Modified Example>

According to the present modified example, the modifying agent supply step S19 is different from that of the embodiments mentioned above. According to the present modified example, it is possible to obtain substantially the same effects as in the embodiments mentioned above.

In the modifying agent supply step S19 of the present modified example, instead of the modifying agent activated by the heat, the modifying agent activated by the plasma is used. That is, a plasma treatment is performed.

Specifically, the valve 243c is opened to supply the modifying agent into the gas supply pipe 232c. After the flow rate of the modifying agent is adjusted by the MFC 241c, the modifying agent whose flow rate is adjusted is plasma-excited in the nozzle 249c and the buffer chamber 237 to be supplied into the process chamber 201, and is exhausted through the exhaust pipe 231. In the present step, the modifying agent activated by the plasma excitation is supplied to the wafer 200. In the present step, the valves 243d through 243f are opened at the same time to supply the inert gas into the gas supply pipes 232d to 232f.

For example, process conditions of supplying the modifying agent activated by the plasma to the wafer 200 in the present step are as follows:
A process pressure: from 1 Pa to 100 Pa;
A supply time (time duration) of supplying each gas: from 1 second to 120 seconds, preferably from 1 second to 60 seconds;
A process partial pressure of the modifying agent: from 0.01 Pa to 100 Pa; and
The high frequency power: from 50 W to 1,000 W.

In the present specification, a process sequence of the substrate processing according to the present modified example may be illustrated as follows. For convenience, the modifying agent activated by the plasma is illustrated as a "modifying agent*".

(First fluorine-containing gas → Reactive gas) × n → Second fluorine-containing gas × m → Modifying agent

As the modifying agent, for example, a reactive species generated by activating a gas containing at least one among the rare gas, the oxygen-containing gas and a hydrogen (H)-containing may be used. Thereby, the substance Y contained in the film can be desorbed and removed. As a result, it is possible to reduce the amount of the impurities contained in the film. Thereby, it is possible to improve electrical characteristics of the film.

As the rare gas, for example, one or more among argon (Ar) gas, helium (He) gas, neon (Ne) gas and xenon (Xe) gas may be used. As the oxygen-containing gas, for example, one or more among the O₂, the O₃, the N₂O, the NO, the NO₂, the CO, the CO₂, the H₂O, the H₂O₂, the H₂ + the O₂, and the H₂ + the O₃ may be used. Further, one or more among H₂, H₂O, H₂O₂, H₂+O₂, H₂+O₃ and the like may be used as the hydrogen-containing gas.

### <Other Embodiments>

For example, the embodiments mentioned above are described by way of an example in which the first fluorine-containing gas supply step S11 to the exhaust step S20 are performed continuously (in situ) in the same process chamber 201. However, the technique of the present disclosure is not limited thereto. For example, the step S11 (that is, the first fluorine-containing gas supply step S11) to the step S18 (that is, the step of performing the cycle the predetermined number of times) and the modifying agent supply step S19 to the exhaust step S20 may be performed in different process chambers (ex situ). Even in such a case, it is possible to obtain substantially the same effects as in the embodiments mentioned above. Further, when the first fluorine-containing gas supply step S11 to the exhaust step S20 are performed continuously (in situ) in the same process chamber 201, it is possible to further reduce the time for transferring the wafer 200 between the process chambers. Therefore, it is possible to improve the productivity.

For example, the embodiments mentioned above are described by way of an example in which the etching process of etching the film formed on the wafer 200 is performed. However, the technique of the present disclosure is not limited thereto. For example, the technique of the present disclosure may also be preferably applied to a process of etching a film formed on a surface of a component such as an inner wall of the process chamber 201 and the boat 217. That is, the technique of the present disclosure may also be preferably applied to a cleaning process of the process chamber 201. For example, the technique of the present disclosure may also be preferably applied when the film is formed on the wafer 200 in the process chamber 201 and then the film is etched in the process chamber 201. Even in such a case, it is possible to obtain substantially the same effects as in the embodiments mentioned above.

For example, the embodiments mentioned above are described by way of an example in which the first fluorine-containing gas supply step S11, the exhaust step S12, the reactive gas supply step S13 and the exhaust step S14 are sequentially performed in this order in the etching cycle. However, the technique of the present disclosure is not limited thereto. For example, in the etching cycle, the reactive gas supply step S13, the exhaust step S14, the first fluorine-containing gas supply step S11 and the exhaust step S12 may be sequentially performed in this order. Even in such a case, it is possible to obtain substantially the same effects as in the embodiments mentioned above.

It is preferable that recipes used in processes (substrate processing) are prepared individually in accordance with contents of the processes and stored in the memory 121c via an electric communication line or the external memory 123. When starting each process (substrate processing), it is preferable that the CPU 121a selects an appropriate recipe among the recipes stored in the memory 121c in accordance with the contents of each process. Thus, various films of different composition ratios, qualities and thicknesses can be formed in a reliably reproducible manner by using a single substrate processing apparatus (that is, the substrate processing apparatus described above). In addition, since a burden on an operating personnel in charge of the substrate processing apparatus can be reduced, various processes can be performed quickly while avoiding an error in operating the substrate processing apparatus.

The recipe described above is not limited to creating a new recipe. For example, the recipe may be prepared by changing an existing recipe stored (or installed) in the substrate processing apparatus in advance. When changing the existing recipe to a new recipe, the new recipe may be installed in the substrate processing apparatus via the electric communication line or a recording medium in which the new recipe is stored. Further, the existing recipe already stored in the substrate processing apparatus may be directly changed to the new recipe by operating the input/output device 122 of the substrate processing apparatus.

For example, the embodiments mentioned above are described by way of an example in which a batch type substrate processing apparatus capable of simultaneously processing a plurality of substrates at a time is used. However, the technique of the present disclosure is not limited thereto. For example, the technique of the present disclosure may also be preferably applied when a single wafer type substrate processing apparatus capable of simultaneously processing one or several substrates at a time is used. For example, the embodiments mentioned above are described by way of an example in which a substrate processing apparatus including a hot wall type process furnace is used. However, the technique of the present disclosure is not limited thereto. For example, the technique of the present disclosure may also be preferably applied when a substrate processing apparatus including a cold wall type process furnace is used.

The process procedures and the process conditions of each process (such as a film forming process) using the substrate processing apparatuses exemplified above may be substantially the same as those of the embodiments mentioned above or the modified examples mentioned above. Even in such a case, it is possible to obtain substantially the same effects as in the embodiments mentioned above.

Further, the embodiments mentioned above and the modified examples mentioned above may be appropriately combined. The process procedures and the process conditions of each combination thereof may be substantially the same as those of the embodiments described above or the modified examples mentioned above.

Hereinafter, an experimental example of the present disclosure will be described.

### <Experimental Example>

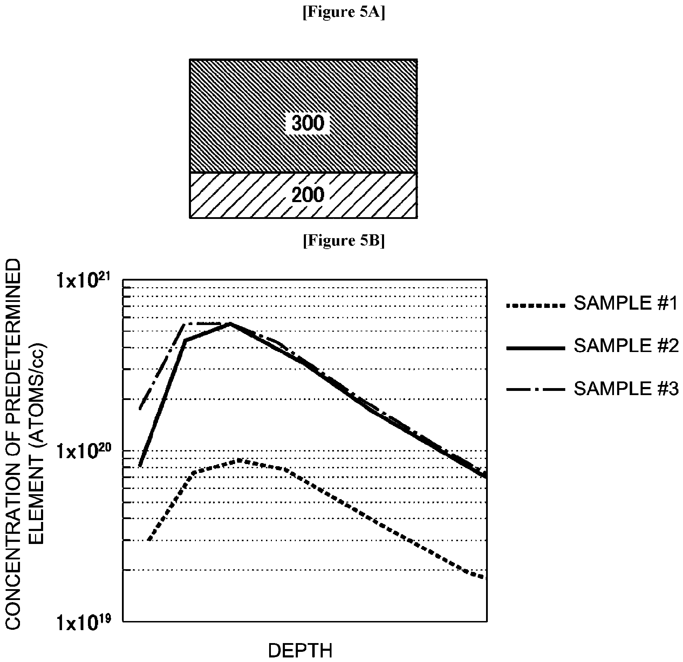

As shown in FIG. 5A, samples #1 to #3 are prepared in which a metal oxide film 300 is formed on the surface of the wafer 200. The sample #1 is prepared by forming the metal oxide film 300 on the surface of the wafer 200. The sample #2 is prepared by forming the metal oxide film 300 on the surface of the wafer 200 under the same conditions as the sample #1, supplying the reactive gas and then supplying the fluorine-containing gas to the wafer 200 using the substrate processing apparatus mentioned above. The sample #3 is prepared by forming the metal oxide film 300 on the surface of the wafer 200 under the same conditions as the sample #1 and then supplying the reactive gas to the wafer 200 using the substrate processing apparatus mentioned above.

FIG. 5B is a diagram schematically illustrating results of analyzing a concentration of the predetermined element in the metal oxide film 300 of each of the samples #1 to #3 by the secondary ion mass spectrometry (SIMS). The process conditions in each step of preparing the samples #2 and #3 are set to be within the range defined by the process conditions in each step of the embodiments mentioned above. A horizontal axis of FIG. 5B represents a depth from the surface of the metal oxide film 300, and a vertical axis of FIG. 5B represents the concentration of the predetermined element.

Comparing the sample #1 and the sample #3, it can be seen that, in the vicinity of the surface of the metal oxide film 300, the concentration of the predetermined element in the sample #3 is higher than the concentration of the predetermined element in the sample #1. Therefore, it can be seen that the predetermined element is incorporated into the metal oxide film 300 by supplying the reactive gas.

In addition, comparing the sample #2 and the sample #3, it can be seen that, in the vicinity of the surface of the metal oxide film 300, the concentration of the predetermined element in the sample #2 is lower than the concentration of the predetermined element in the sample #3. Therefore, it can be seen that a part of the substance containing the predetermined element incorporated into the metal oxide film 300 is removed by supplying the fluorine-containing gas.

Therefore, as described in the substrate processing in the embodiments mentioned above, it is confirmed that the amount of the predetermined element contained in the film can be reduced by supplying the fluorine-containing gas after supplying the fluorine-containing gas and the reactive gas two or more times.

The invention may be summarized as follows: According to the present disclosure, it is possible to reduce an amount of impurities contained in a film after the film is etched. There is provided a technique that includes: (a) removing at least a part of a film formed on a substrate by performing a cycle two or more times, wherein the cycle includes: (a1) supplying a first fluorine-containing gas to the substrate; and (a2) supplying a reactive gas containing a predetermined element to the substrate; and (b) supplying a second fluorine-containing gas to the substrate after (a), wherein a first substance containing the predetermined element is generated in (a), and wherein the second fluorine-containing gas is supplied in (b) under conditions in which the first substance is converted into a substance whose vapor pressure is lower than that of the first substance.

### [Description of Reference Numerals]

200: wafer (substrate)

## Claims

1. A substrate processing method comprising:
(a) removing at least a part of a film formed on a substrate by performing a cycle two or more times, wherein the cycle comprises:
(a1) supplying a first fluorine-containing gas to the substrate; and
(a2) supplying a reactive gas containing a predetermined element to the substrate; and
(b) supplying a second fluorine-containing gas to the substrate after (a),
wherein a first substance containing the predetermined element is generated in (a), and
wherein the second fluorine-containing gas is supplied in (b) under conditions in which the first substance is converted into a substance whose vapor pressure is lower than that of the first substance.

2. The substrate processing method of claim 1, wherein the first fluorine-containing gas is supplied in (a1) under conditions in which the first substance is converted into a substance whose vapor pressure is lower than that of the first substance.

3. The substrate processing method of claim 1 and/or 2, wherein (a1) is performed under conditions in which a part of the first substance is not removed from the substrate.

4. The substrate processing method of any one or more of claims 1 to 3, wherein an exposure amount of the first fluorine-containing gas in (a1) is set to be smaller than an exposure amount of the first fluorine-containing gas in a case where the first substance on the substrate is completely removed.

5. The substrate processing method of any one or more of claims 1 to 4, wherein an exposure amount of the second fluorine-containing gas in (b) is set to be greater than an exposure amount of the first fluorine-containing gas in (a1).

6. The substrate processing method of any one or more of claims 1 to 5, wherein the second fluorine-containing gas is same as the first fluorine-containing gas.

7. The substrate processing method of any one or more of claims 1 to 6, wherein the second fluorine-containing gas is free of a metal element.

8. The substrate processing method of any one or more of claims 1 to 7, wherein the predetermined element comprises a metal element or a metalloid element.

9. The substrate processing method of any one or more of claims 1 to 8, further comprising
(c) supplying a modifying agent to the substrate after (b),
wherein the modifying agent is capable of removing a second substance containing fluorine on the substrate.

10. The substrate processing method of claim 9, wherein (a), (b) and (c) are performed in a single process chamber.

11. The substrate processing method of claim 9 and/or 10, wherein the modifying agent comprises an oxidizing gas.

12. The substrate processing method of any one or more of claims 9 to 11, wherein the modifying agent comprises a reactive species generated by activating a gas containing at least one selected from the group of a rare gas, an oxygen-containing gas and a hydrogen-containing gas by a plasma.

13. A method of manufacturing a semiconductor device, comprising
the substrate processing method of any one or more of claims 1 to 12.

14. A substrate processing apparatus, in particular for performing the substrate processing method according to any one or more of claims 1 to 12, the substrate processing apparatus comprising:
a first fluorine-containing gas supplier configured to supply a first fluorine-containing gas;
a reactive gas supplier configured to supply a reactive gas containing a predetermined element;
a second fluorine-containing gas supplier configured to supply a second fluorine-containing gas; and
a controller configured to be capable of controlling the first fluorine-containing gas supplier, the reactive gas supplier and the second fluorine-containing gas supplier to perform:
(a) removing at least a part of a film formed on a substrate by performing a cycle two or more times, wherein the cycle comprises:
(a1) supplying the first fluorine-containing gas to the substrate; and
(a2) supplying the reactive gas to the substrate; and
(b) supplying the second fluorine-containing gas to the substrate after (a),
wherein a first substance containing the predetermined element is generated in (a), and
wherein the second fluorine-containing gas is supplied in (b) under conditions in which the first substance is converted into a substance whose vapor pressure is lower than that of the first substance.

15. A program that causes a substrate processing apparatus, by a computer, to perform:
(a) removing at least a part of a film formed on a substrate by performing a cycle two or more times, wherein the cycle comprises:
(a1) supplying a first fluorine-containing gas to the substrate; and
(a2) supplying a reactive gas containing a predetermined element to the substrate; and
(b) supplying a second fluorine-containing gas to the substrate after (a),
wherein a first substance containing the predetermined element is generated in (a), and
wherein the second fluorine-containing gas is supplied in (b) under conditions in which the first substance is converted into a substance whose vapor pressure is lower than that of the first substance.
